# EUROPEAN PATENT APPLICATION

(11) **EP 4 531 077 A1**
(43) Date of publication of application: **02.04.2025**
(21) Application number: 24186750.6
(22) Date of filing: 05.07.2024
(51) Int. Cl.: H01L 21/48, H01L 23/373, H01L 23/31, H01L 21/56, H01L 23/10, H01L 23/24, H01L 23/367, H01L 23/473

(54) **METHOD OF DIRECTLY INTEGRATING POWER ELECTRONICS SUBSTRATE ONTO HEATSINK**

(30) Priority: 26.09.2023 DE 102023209362
(71) Applicant: ZF Friedrichshafen AG, 88046 Friedrichshafen (DE)
(72) Inventor: Yuli, Komatsu, 88046 Friedrichshafen (DE); Hiroyuki, Sakaguchi, 88046 Friedrichshafen (DE)
(74) Representative: ZF Friedrichshafen AG

(57) **Abstract**

Proposed is a method of directly integrating a power electronics substrate onto a heatsink, comprising the steps of providing several three-layer stacks, each of which is made of a top layer of a metal plate, a middle layer of an electrically non-conductive res-in sheet and a bottom layer being a top side of a heatsink, wherein the heatsink comprises a fin structure provided at a bottom side of the heatsink, wherein the fin structure is arranged such that an outer rim of the bottom side is left blank of the fin structure; and providing a metal baseplate plate comprising multiple apertures, each of which is designed to receive one of the stacks, wherein each aperture has a size such that the fin structure of a stack can be completely inserted in the aperture. In one solution, each aperture has a groove along its outer perimeter, in which a sealing ring is inserted, In another solution, a sealing material is placed along an outer perimeter of each aperture and/or the outer rim of the bottom side of the heatsink. Further, generating an ensemble of metal baseplate plate and stacks is conducted by inserting the stacks into the apertures of the metal baseplate plate such that each outer rim of a stack at least partially overlaps with the metal baseplate plate in such way that the stack and the metal baseplate plate are sealed by the sealing ring or the sealing material. Further, a single sheet of bagging film is provided on top of the ensemble, wherein the bagging film has a size of at least the size of the metal baseplate plate, and the area below the bagging film is evacuated. Finally, an autoclave process is applied on the ensemble.

## Description

The present invention refers to a production method by which a more effective heat dissipation from power semiconductors is provided as a result.

In an application of power electronics, the heat generated at the power semiconductors used in the semiconductor chips (circuit) must be dissipated as quickly as possible in order to avoid damage of the semiconductors and their adjacent structures. In general, the power semiconductors are physically mounted on a metallic heatsink which has a heat-dissipating fin structure on the opposite side and is electrically grounded. Since the power semiconductors are electrically connected to the circuit, which also must be electrically isolated from the ground, between the semiconductors and the heatsink, there are some stack layers which should include a metal plate underneath the semiconductors and an insulating layer between the metal plate and the heatsink.

As known from prior art, a ceramic plate typically made of aluminum oxide is used as the insulating layer. Both sides of the ceramic plate are directly bonded to metal plates normally made of copper. This sandwich-like three-layer stack is normally called DBC which stands for "direct bonded copper". One of the metal plates of the DBC is bonded to the bottom side of the power semiconductors using bonding material like solder. The other metal plate is bonded to the heatsink (also preferably made of copper) using thermal interface material (TIM).

The TIM can be also solder, but much softer material like thermal grease is often preferred because the soldering process for the heatsink and the DBC causes a lot of complication. One of the biggest problems is the large difference in the coefficient of thermal expansion (CTE) between the ceramic and the heatsink. Cooling down from the solder-solidifying temperature induces large stress to both and sometimes warp occurs. Thus, the soldering process must be carefully designed so that the stress can be properly released and that the consequent shape is as flat as possible after cooling down. The use of thermal grease can mitigate the problems as stated above, because the process of applying grease can skip the heating process in the assembly step and easily release the stress between the DBC and the heatsink when the DBC is heated by the semiconductors in the semiconductor chips arranged on the top copper plate. On the other hand, the thermal conductivity is generally much smaller than that of solder, and the thickness of the grease layer is very prone to be inhomogeneous both at the assembly step and during the long-time operation including repeated heating-up and cooling-down. This makes the lateral distribution of the thermal resistance at the grease layer very ununiform, which hinders the multiple semiconductors mounted on the DBC to perform at the same temperature due to the different heat dissipating environment. Since the electrical resistance of the semiconductors is very sensitive to the temperature, it is very important to let the semiconductors function at the same temperature to fully exploit their potential ability.

Recently, epoxy-based resin sheet with ceramic particles as the filler is developed as a substitute of the ceramic plate of the DBC. Through the recent improvement of the thermal conductivity of the resin toward almost 1/3 of that of aluminum oxide, equivalent thermal resistance with aluminum oxide has been achieved by realizing necessarily high breakdown voltage at only 1/3 thickness of aluminum oxide. The CTE of the resin can be tailored closely to that of copper, which enables the use of solder for the TIM without inducing various complications caused by the different CTE between the insulating layer and copper when the heatsink is made of copper.

The employment of the resin sheet as the substitute of aluminum oxide of DBC already has a mechanical advantage in the assembling process, but there is still optimization potential both in the assembling process and the heat dissipation effect. Hence, the object of the present invention is to provide a method of integrating power electronics substrate onto a heatsink such that the heat dissipation effect as well as the assembling process are optimized. In DE 10 2023 209 362.6, a method of directly integrating a power electronics substrate onto a heatsink is disclosed. However, there is still optimization potential to this solution.

To optimize the method as disclosed in DE 10 2023 209 362.6, the present invention proposes a method of directly integrating a power electronics substrate onto a heatsink, comprising the steps of providing several three-layer stacks, each of which is made of a top layer of a metal plate, a middle layer of an electrically non-conductive resin sheet and a bottom layer being a top side of a heatsink, wherein the heatsink comprises a fin structure provided at a bottom side of the heatsink, wherein the fin structure is arranged such that an outer rim of the bottom side is left blank of the fin structure; and providing a metal baseplate plate comprising multiple apertures, each of which is designed to receive one of the stacks, wherein each aperture has a size such that the fin structure of a stack can be completely inserted in the aperture. In one solution, each aperture has a groove along its outer perimeter, in which a sealing ring is inserted. In another solution, a sealing material is placed along an outer perimeter of each aperture and/or the outer rim of the bottom side of the heatsink. Further, generating an ensemble of metal baseplate plate and stacks is conducted by inserting the stacks into the apertures of the metal baseplate plate such that each outer rim of a stack at least partially overlaps with the metal baseplate plate in such way that the stack and the metal baseplate plate are sealed by the sealing ring or the sealing material. Further, a single sheet of bagging film is provided on top of the ensemble, wherein the bagging film has a size of at least the size of the metal baseplate plate, and the area below the bagging film is evacuated. Finally, an autoclave process is applied on the ensemble

In one embodiment, the layers of each stack are pre-fixed to each other.

In one embodiment the sheet of bagging film has a vacuum sealing adhesive at edges of the metal baseplate plate and is fixed to the metal baseplate plate.

In one embodiment a breather fabric is provided for filling of gaps underneath the sheet of bagging film, and at least one air tube is provided in the sheet of bagging film and/or in the metal plate for evacuating the gaps.

In one embodiment the fin structure is made of pinfins.

In one embodiment the metal plate is structured into metal plate islands at the time of generating the stack.

In one embodiment the semiconductor chips are arranged on the metal plate islands after the autoclave process.

In one embodiment the metal plate is made of copper. In one embodiment, the surface of metal plate made of copper is covered by another metal.

In one embodiment the sealing material is a vacuum sealing material, comprising an adhesive.

For a more complete understanding of the invention, the invention will now be described in detail with reference to the accompanying drawings. The detailed description will illustrate and describe what is considered as preferred embodiments of the invention. It should of course be understood that various modifications and changes in form or detail could readily be made without departing from the spirit of the invention. It is therefore intended that the invention may not be limited to the exact form and detail shown and described herein, nor to anything less than the whole of the invention disclosed herein and as claimed herein after. Further, the features described in the description, the drawings and the claims disclosing the invention may be essential for the invention considered alone or in combination. In particular, any reference signs in the claims shall not be construed as limiting the scope of the invention.

In the accompanying drawings:
Figure 1 shows a DBC arranged on a heatsink according to prior art;
Figure 2 shows a three-stack layer to be processed according to one embodiment of the invention.
Figure 3 shows a ready-to-be-evacuated stack according to one embodiment of the invention.
Figure 4 shows a ready-to-be-processed by an autoclave process stack according to one embodiment of the invention.
Figure 5 shows a metal plate with multiple apertures according to one embodiment of the invention.
Figure 6 shows an enlarged view of two apertures and their grooves according to one embodiment of the invention.
Figure 6b shows an enlarged view of two apertures with a sealing material around an outer perimeter according to another embodiment of the invention.
Figures 7a and 7b each show a metal plate with two stacks placed such that their fin structure is inserted in the metal plate's aperture before evacuation according to two different embodiments of the invention.
Figure 8 shows a flow chart of the method according to one embodiment of the invention.
Figure 9 shows an enlarged view a metal plate with two stacks and a position of an air tube for evacuation according to one embodiment of the invention.

While the present disclosure is subject to various modifications and alternative forms, specific embodiments thereof have been shown by way of example in the drawings and will herein be described in detail. The invention should be understood to not be limited to the particular forms disclosed, but on the contrary, the intention is to cover all modifications, equivalents, and alternatives falling within the spirit and scope of the present disclosure.

In the following, embodiments are described with reference to metal plates made of copper, since this is the material mostly used. As a matter of course, also other metals instead of copper can be used where appropriate. Also, the surface of a copper plate can be covered by another metal such as silver or nickel. Further, the invention is not limited to the use of DBC as substrate. Also other substrates having at least a top metal plate, an insulating layer and a heatsink can be used, where appropriate.

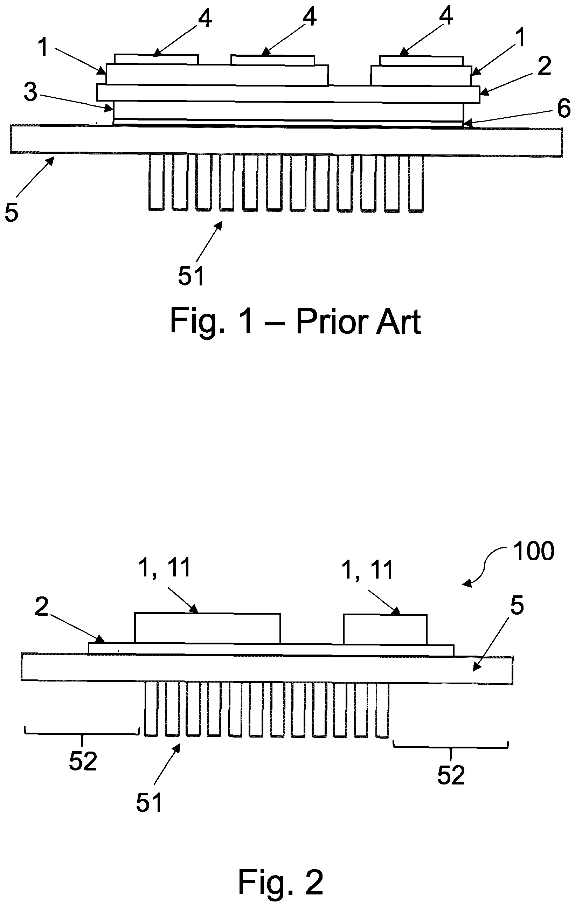

In Figure 1 a DBC with a top copper plate 1 and a bottom copper plate 3 sandwiching a ceramic or an epoxy-based resin layer 2 as known from prior art is schematically shown. The top copper plate 1 is processed e.g. by etching such that copper plate islands 11 for carrying semiconductor chips 4 such as highside and lowside switches are generated. A heatsink 5 with a fin structure 51 on its bottom side is connected via a thermal interface material 6 to the bottom side of the bottom copper plate 3.

As already mentioned, the employment of the resin sheet 2 as the substitute of aluminum oxide of DBC already has a mechanical advantage in the assembling process. However, there is still optimization potential.

Thus, a new design is provided, in which the resin sheet 2 is directly pasted on the heatsink 5 so that a three-stack layer 100 made of the layers top copper plate 1, resin sheet 2 and heatsink 5 with a fin structure 51 is provided. With this design structure, TIM and the other copper plates 3 are eliminated from the stack of the DBC and the heatsink 5 as shown in Figure 1, which makes the thermal resistance even smaller to dissipate the heat from the power semiconductor chips 4. The direct resin pasting on the heatsink 5 even enables the integration of 6-in-1 power module circuit and heatsink with keeping each copper plate island 11 electrically isolated. This structure decreases the subsequent process steps and reduces the production cost of semiconductor power modules.

However, there is a difficulty to integrate this three-stack layer 100 made of the top copper plate 1, preferably being already processed such that copper plate islands 11 for receiving the semiconductor chips 4 (after the autoclave process) are already present, the resin sheet 2, and the heatsink 5, including at its bottom side a heat-dissipating fin structure 51. This is, because almost all types of available resin sheets require a curing process at relatively high temperature around 200 degrees Celsius with a mechanical press whose pressure should be normally larger than 1 MPa and uniform all over the resin sheet 2 including the area where copper plate islands 11 do not exist (i.e. the gap between them).

In a conventional manufacturing method, such copper islands 11 are formed by chemical etching after the curing process using a single copper plate 1 with almost equivalent size of the resin sheet 2. By doing so, the resin sheet 2 should be properly cured with uniform pressure, at least from the top side where the flat surface of the copper plate 1 is touched with the top-side stage of the presser. However, the bottom-side stage of the presser has a problem to press uniformly. The stage should not be flat but somehow adjusted to the bottom of the heat-dissipating fin structure 51. Nevertheless, applying uniform pressure from the bottom side is not easy due to the non-flat surface of the bottom side of the heatsink 5 and it is prone to hinder long-time reliability of the product by imperfect bonding between the resin sheet 2 and the copper plate 1.

Instead of mechanical press, a so-called autoclave process can solve the problem described above. In such a process, the physically stacked materials (copper plate 1, resin sheet 2 and heatsink 5) are put into an airtight chamber and pressed by high-pressure air around 1 MPa filled in the chamber. Since the pressure is uniform toward any direction, pressing even from the bottom side of the heatsink conveys the force uniformly to the resin sheet 2. It is also possible that already patterned copper islands 11 can be pressed because the high-pressure air presses the resin at the gap between the copper plate islands 11 equally with the copper islands 11.

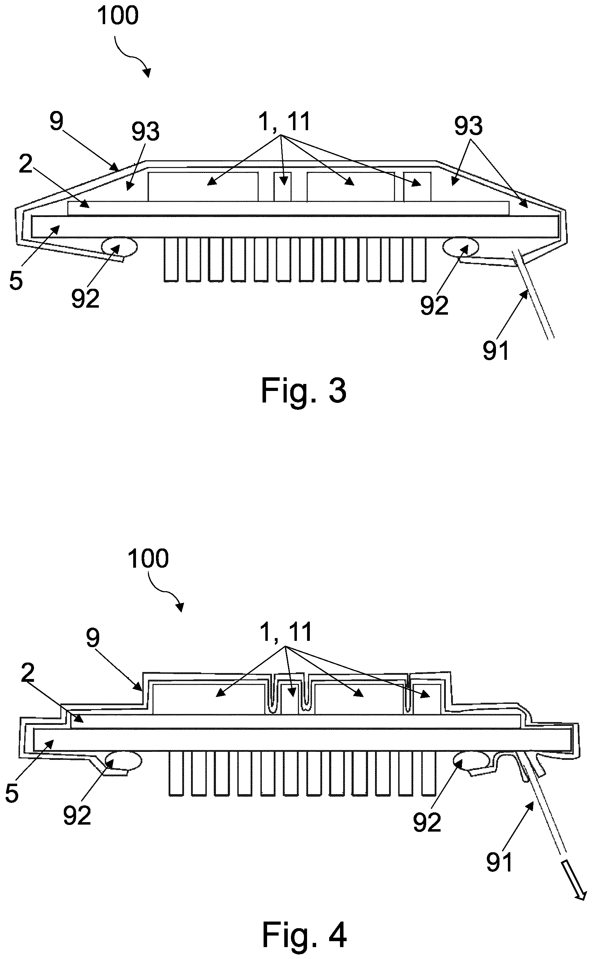

In order to apply an autoclave process, the stack 100 of the heatsink 5, the resin sheet 2 and the copper plate 1 is covered with a bagging film 9 typically made of multilayer nylon which is hard to tear. The edge of the bagging film 9 is sealed by a vacuum sealing adhesive 92 at the rear side of the heat sink 5 outside the heat-dissipating fin structure 51. Further, a breather fabric 93, which is a non-woven felt-like material typically made of polyester, can be filled between the bagging film 9 and the stack 100, to help evacuation of the gaps underneath the bagging film 9, especially from the slit/gap between the heatsink 5 and the resin sheet 2, and between the resin sheet 2 and the copper plates 1. Before high-pressure air is applied, the space between the bagging film 9 and the stack 100 must be sufficiently evacuated so that the volume of the breather fabric 93 should be shrunk as thin as possible. The (optional) breather fabric 93 helps evacuating the slits/gaps on and beneath the resin sheet 2. This is done by sucking air from the gaps underneath the bagging film 9 through one or more air tubes 91 attached to the bagging film 9 (providing an air tube 91 in the bagging film 9 is standard in autoclave processes). Then, with keeping evacuation, the whole chamber is heated up to the curing temperature of the resin of the resin sheet 2 and high-pressure air is applied for the necessary duration for curing. The ready-to-be-evacuated stack 100 is shown in Figure 3. The ready-to-be-processed by an autoclave process, i.e. evacuated, stack 100 is shown in Figure 4.

The major drawback of this process is its cost. The chamber itself is relatively expensive and same for the apparatus to apply high-pressure air. This kind of problem must be overcome by large-scale production. Nevertheless, evacuating the stack 100 one-by-one will require additional labor and time.

Hence, preparation of a large-size chamber and increasing the number of stacks 100 to be processed in one time will help to reduce the average process cost for stack 100 of the heatsink 5. This invention provides a solution to at least the above-mentioned problem.

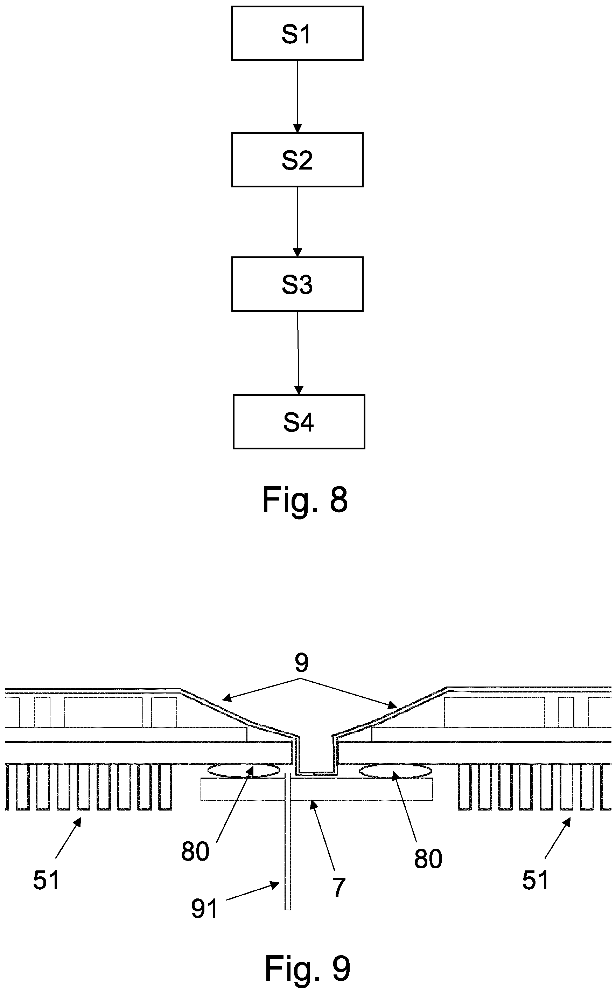

According to the invention, a method of directly integrating power electronics substrate, i.e. the copper plate 1 structured into copper plate islands 11 for carrying the semiconductor chips 4, onto the heatsink 5 is provided and presented in the following. Figure 8 shows a flow chart of the method.

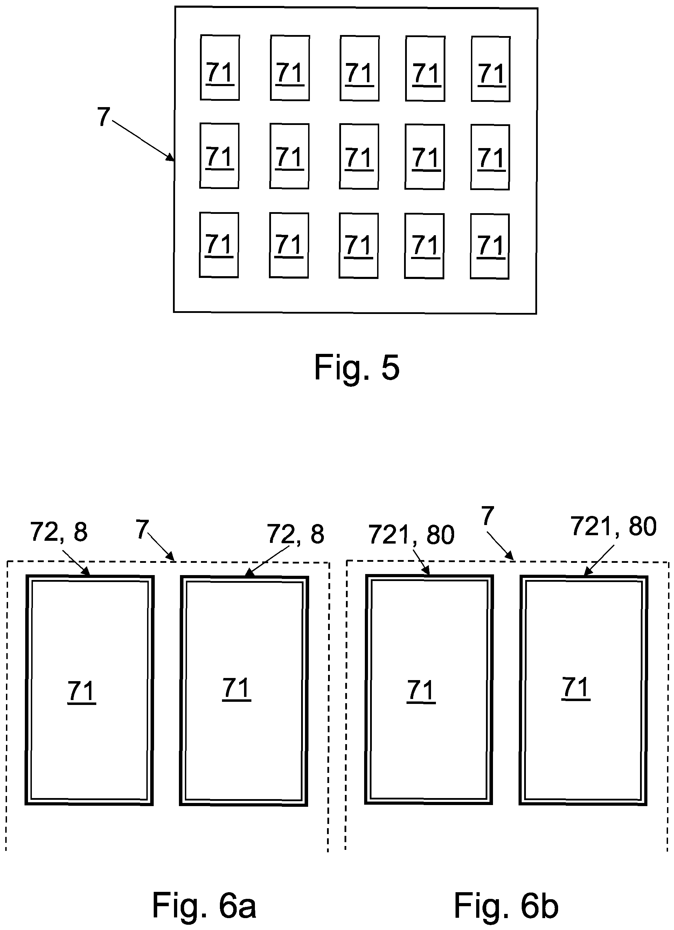

One of the requirements of the invention is a metal baseplate 7 (step S1). Such metal baseplate 7 is typically made of (stainless) aluminum alloy with a typical thickness of 10 mm. The metal baseplate 7 has multiple apertures 71 for receiving the same number of the heat-dissipating heatsinks 5 (as part of a stack 100), as shown in Figure 5. Hence, the metal baseplate's 7 width and depth are such that the metal baseplate 7 can receive several stacks 100. Therefore, its width and depth can be e.g. around 1m x 1m, which is not too small considering the purpose described later and not too large considering the weight of the total loads on it.

In one solution for the problem of the invention, each aperture 71 has a groove 72 around it, as shown in Figure 6a. The purpose of the groove 72 is to place a sealing ring 8 such as an O-ring with the length to fit the perimeter of the groove 72 and the thickness which is wider than the depth of the groove. Such a sealing ring is typically made of FFKM (perfluorelastomer) or FKM (Fluorine Kautschuk Material). In an alternative solution for the problem of the invention, each aperture 71 has an outer perimeter 721, around which a sealing material 80 such as a vacuum sealing material, specifically an adhesive, is applied, as shown in Figure 6b.

Additionally, a three-layer stack 100 is generated by stacking the heatsink 5, the resin sheet 2 and the copper plates 1 together (step S1). In order to prevent the layers 5, 2, 1 from moving relative to each other before being finally fixed to each other by the autoclave process, they are pre-fixed with each other by an adhesive. Depending on where the adhesive is placed, it needs to be thermo-conductive (when placed near the location where the semiconductor chips 4 are arranged later) or less-thermo-conductive (when placed e.g. at edges or corners of the layer, which are as far as possible from the semiconductor chips 4).

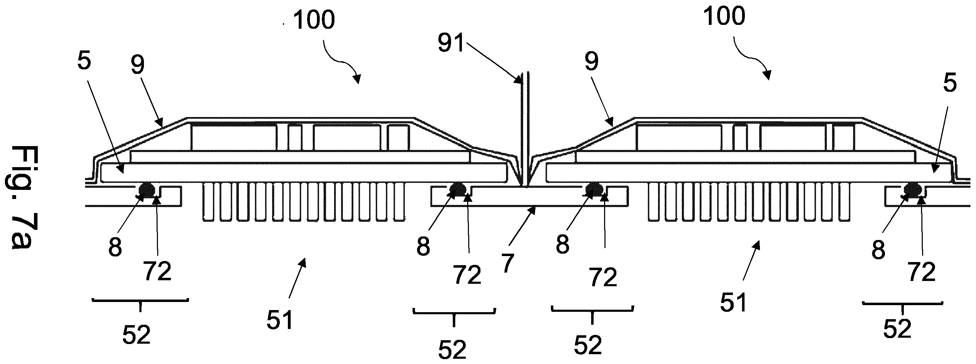

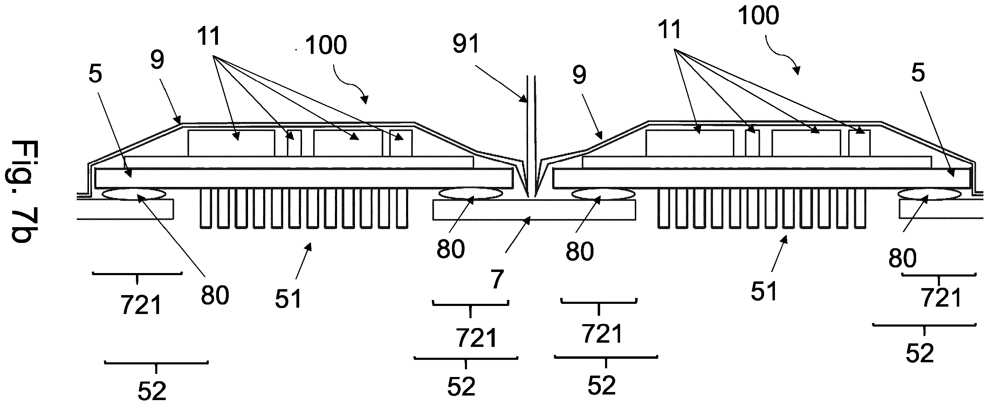

Further, an ensemble is generated by placing each stack 100 on the metal baseplate 7 (step S2) such that the fin structure 51, which can be pinfins or another protruding structure being able to dissipate heat, are inserted in the aperture 71 such that they stick out at the bottom side of the metal baseplate 7, as can be seen in Figures 7a and 7b. In Figures 7a and 7b it is also shown that the heatsink 5, i.e. the sheet thereof, has the fin structure 51 only on part of its bottom side. The fin structure 51 is provided such that an outer rim 52 of the bottom side of the sheet is left blank, see e.g. Figure 2.

In the first solution of the problem of the invention, on the outer rim 52 (or at least part of it), the heatsink 5 overlaps with the metal baseplate 7 after bringing both together. Specifically, the groove 72 and the sealing ring 8 are designed to seal the surrounding of the fin structure 51 to prevent air to leak when the sealing ring 8 is pressed by both the heatsink 5 and the metal baseplate 7. Especially in the case that the heatsink 5 is intended for the application of water-cooling, the same size of the aperture 71 and the groove 72 for a cooling jacket to be used can be employed.

In the second (alternative) solution of the problem of the invention, on the outer rim 52 (or at least part of it), the heatsink 5 overlaps with the metal baseplate 7 after bringing both together. Specifically, the outer perimeter 721 with the sealing material 80 are designed to seal the surrounding of the fin structure 51 to prevent air to leak when the sealing material 80 is pressed by both the heatsink 5 and the metal baseplate 7. In one embodiment, the sealing material 80, e.g. a vacuum sealing material, specifically an adhesive, is applied around the outer perimeter 72 or the outer rim 52. In another embodiment, the sealing material 80 is applied on both, the outer rim 52 and the outer perimeter 72.

The provision of the metal baseplate 7 and the generation of the three-layer stack 100 can be done at the same time, since two different processes are needed, or in consecutive steps.

Furthermore, in order to employ the autoclave process, a bagging film 9 is needed. According to the invention, a sheet of bagging film 9 is used (step S3) that has at least the size (depth and width) of the metal baseplate 7. That means that only one sheet for all stacks 100 is needed instead of one sheet per stack 100. This is only possible by the introduction of the metal baseplate 7. The sheet of bagging film 9 covers the metal baseplate 7, on which the stacks 100 with the heatsinks 5 are located, sealed from the aperture 71 by the sealing rings 8 or the sealing materials 80 (depending on the applied solution). Additionally, breather fabric 93 can be filled underneath the sheet of bagging film 9 in order to optimize evacuation. Also, the sheet of bagging film 9 must have one or several air tubes 91 for evacuation, and vacuum sealing adhesive 92 at its edge (connected to the metal baseplate 7) in order to be able to generate vacuum. Hence, by providing one metal baseplate 7 with only one sheet of bagging film 9, the number of the vacuum systems to evacuate on and beneath the resin sheet 2 can be significantly reduced. This leads to the reduction of the process cost and the process steps, when a large number of the stacks 100 of heatsink 5 / resin sheet 2 / copper plates 1 are loaded in one autoclave chamber at once for employing the autoclave process.

As already mentioned, providing an air tube 91 in the bagging film 9 as shown in e.g. Figures 7a and 7b, is standard in an autoclave process. According to an embodiment, the air tube 91 is no longer provided in the bagging film 9 but in the metal plate 7. That means that an air tube 91 is inserted from outside through a hole in one of the metal plates 7 such that it reaches into at least one of the portions (gaps or gaps filled with breather fabric 93) to be evacuated through the metal plate 7, as shown in Figure 9 (being an enlarged view of Figure 7b as example). It might be advantageous to provide one air tube 91 for each metal plate 7. It might also be advantageous to provide more than one air tube 91 for each metal plate 7 in order to provide a more continuous evacuation for two neighboring stacks, or to provide a faster evacuation. Providing the air tubes 91 in the metal plate 7 instead of in the bagging film 9 is applicable for both solutions of the invention, i.e. the solution having a groove 72 and a sealing ring 8 as well the solution having a sealing material 80 around the outer perimeter 721 instead of the groove 72 with the sealing ring 8.

Providing one or more air tubes 91 in the metal plate 7 has the advantage that the air tube(s) 91 can be used repetitively. In case the air tube 91 is provided in the bagging film 9, the bagging film 9 needs to be holed each time but the holes for the plate 7 can be permanent, thus speeding up the setup process.

After the evacuation is done, the ensemble is put in an autoclave chamber in order to be processed by an autoclave process (step S4). By applying the autoclave process, the three layers copper plate 1, resin sheet 2 and heatsink 5 are pressed together at a certain temperature such that the resin sheet 2 functions as adhesive. After finishing the autoclave process, each stack can be removed from the aperture 71 and the semiconductor chips 4 can be arranged on the copper plate islands 11 and the thus finished device can be used e.g. as part of an inverter for automotive applications, depending on the function of the semiconductor chips 4.

By applying the autoclave process as described, a further advantage can be obtained. Namely, due to pressing the copper plate 1 being already separated into several copper plate islands 11 and the resin sheet 2 and the heatsink 5 in the process together, a copper plate 1 thicker than 0.8mm can be used and the copper plate islands 11 can have an edge closer to vertical than before.

Conventionally, the resin sheet 2 is mechanically pressed sandwich-like with stacked copper plates 1, 3 on both sides. The top copper plate 1 is later separated into several copper plate islands 11, because the gap between copper plate islands 11 needs to be pressed equally as the region beneath the copper plate islands 11. This can only be done with the top copper plate 1 not being processed before pressing the stack together. The isolation is normally carried out by chemical etching using patterned etching resist. Due to the side effect of chemical etching, the side wall of the copper plate islands 11 will be tapered around 45 to 60 degrees, and the edge shape of the top surface becomes more ambiguous when the copper plate 1 is thicker.

Furthermore, the minimum distance between the copper plate islands 11 is desired to be 1 mm to avoid electric discharge when high voltage is applied between the copper plate islands 11. On the other hand, the area of the top surface is desired to be utilized as much as possible. Therefore, a top copper plate 1 thicker than 0.8 mm is not realistic on the product control point of view. On the other hand, thermal simulation reveals that a top plate as thick as 2 mm to 3 mm will more effectively dissipate the heat generated at power semiconductor chips 4 mounted on the top copper plate 1. If autoclave process is employed as resin integration process, copper plate islands 11 can be patterned before stacking with the resin sheet 2 and the heatsink 5 because the high air pressure will press even the gap between copper plate islands 11 as equal as the region beneath the copper plate islands 11. The method of isolation is not limited to chemical patterning etching, and the taper problem can be almost avoided.

According to the invention, resin integration by autoclave leads to more effective heat dissipation from power semiconductor chips 4.

### Reference numerals

- 100: three-stack layer
- 1: top copper plate
- 11: copper plate islands
- 2: resin sheet
- 3: bottom copper plate
- 4: semiconductor chips
- 5: heatsink
- 51: fin structure
- 52: outer rim
- 6: thermal interface material (TIM)
- 7: metal baseplate
- 71: aperture
- 72: groove
- 721: outer perimeter
- 8: sealing ring
- 80: material
- 9: bagging film
- 91: air tube
- 92: vacuum sealing adhesive
- 93: breather fabric

## Claims

1. Method of directly integrating a power electronics substrate onto a heatsink (5), comprising the steps of:
- S1: providing several three-layer stacks (100), each of which is made of a top layer of a metal plate (1), a middle layer of an electrically non-conductive resin sheet (2) and a bottom layer being a top side of a heatsink (5), wherein the heatsink (5) comprises a fin structure (51) provided at a bottom side of the heatsink (5), wherein the fin structure (51) is arranged such that an outer rim (52) of the bottom side is left blank of the fin structure (51); and providing a metal baseplate (7) comprising multiple apertures (71), each of which is designed to receive one of the stacks (100), wherein each aperture (71) has a size such that the fin structure (51) of a stack (100) can be completely inserted in the aperture (71), and
wherein each aperture (71) has a groove (72) along its outer perimeter, in which a sealing ring (8) is inserted, or
wherein a sealing material (80) is placed along an outer perimeter (721) of each aperture (71) and/or the outer rim (52) of the bottom side of the heatsink (5),
- S2: generating an ensemble of metal baseplate (7) and stacks (100) by inserting the stacks (100) into the apertures (71) of the metal baseplate (7) such that each outer rim (52) of a stack (100) at least partially overlaps with the metal baseplate (7) in such way that the stack (100) and the metal baseplate (7) are sealed by the sealing ring (8) or the sealing material (80),
- S3: providing a single sheet of bagging film (9) on top of the ensemble, wherein the bagging film (9) has a size of at least the size of the metal baseplate (7), and evacuating the area below the bagging film (9),
- S4: applying an autoclave process on the ensemble.

2. Method according to claim 1, wherein in step S1 the layers of each stack (100) are pre-fixed to each other.

3. Method according to claim 1 or claim 2, wherein the sheet of bagging film (9) has a vacuum sealing adhesive (92) at edges of the metal baseplate (7) and is fixed to the metal baseplate (7) in step S3.

4. Method according to any one of the preceding claims, wherein a breather fabric (93) is provided for filling of gaps underneath the sheet of bagging film (9).

5. Method according to any one of the preceding claims, wherein at least one air tube (91) is provided in the sheet of bagging film (9) and/or in the metal plate (7) for evacuating the gaps.

6. Method according to any one of the preceding claims, wherein the fin structure (51) is made of pinfins.

7. Method according to any one of the preceding claims, wherein the metal plate (1) is structured into metal plate islands (11) at the time of generating the stack (100).

8. Method according to any one of the preceding claims, wherein semiconductor chips are arranged on the metal plate islands after the autoclave process.

9. Method according to any one of the preceding claims, wherein the metal plate (1) is made of copper.

10. Method according to claim 9, wherein the surface of the metal plate (1) made of copper is covered by other metal.

11. Method according to any one of the preceding claims, wherein the sealing material (80) is a vacuum sealing material, comprising an adhesive.
